(19) Europäisches Patentamt
European Patent Office
Office européen des brevets

(11) Veröffentlichungsnummer: **0 239 868**
**B1**

(12) **EUROPÄISCHE PATENTSCHRIFT**

(45) Veröffentlichungstag der Patentschrift: **27.12.89**

(51) Int. Cl.[4]: **G03F 7/02**, G03C 1/72, C07D 235/02

(21) Anmeldenummer: **87103892.3**

(22) Anmeldetag: **17.03.87**

(54) **Fotochromes System, damit hergestellte Schichten und deren Verwendung.**

(30) Priorität: **20.03.86 DE 3609320**

(43) Veröffentlichungstag der Anmeldung: **07.10.87 Patentblatt 87/41**

(45) Bekanntmachung des Hinweises auf die Patenterteilung: **27.12.89 Patentblatt 89/52**

(84) Benannte Vertragsstaaten: **DE FR GB IT NL**

(56) Entgegenhaltungen: **Keine Entgegenhaltungen.**

(73) Patentinhaber: **BASF Aktiengesellschaft, Carl-Bosch-Strasse 38, D-6700 Ludwigshafen(DE)**

(72) Erfinder: **Loerzer, Thomas, Dr., Sonnenweg 10, D-7604 Urloffen 6 (Appenweier)(DE)**
Erfinder: **Leyrer, Reinhold J., Dr., Menzelstrasse 4, D-6700 Ludwigshafen(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 239 868 B1

ACTORUM AG

**Beschreibung**

Die vorliegende Erfindung betrifft ein neues fotochromes Systems, damit hergestellte fotochrome Schichten sowie deren Verwendung zur Herstellung von Aufzeichnungsmaterialien, insbesondere für lithographische Schichten und für andere drucktechnische Verfahren.

Bildformende Kompositionen und Prozesse spielen eine bedeutende Rolle bei der Anwendung von Aufzeichnungsmaterialien, so z.B. bei der Herstellung von Reliefdruckplatten, lithographischen Druckformen, gedruckten Schaltungen etc. Im Rahmen dieser Anwendungen belichtet man diese Aufzeichnungsmaterialien bildmäßig mit aktinischem Licht, während sie mit einer Kopiervorlage in Berührung stehen. Die Belichtung wird dabei gewöhnlich als Kontaktbelichtung oder auf reflektographischem Wege durchgeführt. Nach Belichtung werden derartige Aufzeichnungsmaterialien beispielsweise durch Auswaschen mit Lösungsmitteln, Aufstäuben von Pigmenten oder Ausnutzung unterschiedlicher Haftfestigkeit zwischen belichteten und unbelichteten Schichtteilen entwickelt. Bei der Beurteilung der bildmäßigen Belichtung eines Aufzeichnungsmaterials ist es von Bedeutung, daß durch die Bestrahlung mit aktinischem Licht eine Farbänderung in der Schicht hervorgerufen wird. Auf diese Weise ist es z.B. möglich, unbelichtete und belichtete Bereiche voneinander zu unterscheiden. Fehler, die z.B. auf verschmutzte Vorlagen zurückzuführen sind, können so leicht erkannt werden. Außerdem kann das durch Belichten hergestellte Bild zur Justierung, die bei bestimmten Anwendungen nötig ist, herangezogen werden.

Das fotochrome Farbstoffsystem muß verschiedene Anforderungen erfüllen, um in den oben genannten Bereichen eingesetzt werden zu können. Die spektrale Empfindlichkeit sollte im Bereich von 250 - 400 nm liegen, um so die handelsüblichen Lichtquellen optimal auszunutzen. Gegebenenfalls sollte die spektrale Empfindlichkeit bis an die Grenze des sichtbaren Lichts heranreichen. Weiterhin sollte das fotochrome System - auch bei thermischer Belastung - eine hohe Lagerstabilität aufweisen.

Aus dem US-Patent 3,445,234 ist bekannt, daß Hexaarylbisimidazole in Verbindung mit Aminotriarylmethanen, z.B. Kristallviolettleukobase, als fotochromes Farbstoffsystem verwendet werden. Nachteilig bei diesem System ist, daß das Fotooxidationsmittel Hexaarylbisimidazol thermisch in Radikale zerfällt und es deshalb spezieller Stabilisatoren bedarf, um diesen thermischen Farbumschlag zu verhindern oder wenigstens einzuschränken.

Der vorliegenden Erfindung lag die Aufgabe zugrunde, für insbesondere bei Raumtemperatur feste Überzugs- und Aufzeichnungsmaterialien ein fotochromes Farbsystem zu finden, das eine hohe spektrale Empfindlichkeit und gleichzeitig eine bessere Lagerstabilität aufweist.

Überraschenderweise wurde nun gefunden, daß am Imidazolring in 1-Stellung substituierte 2-Phenylphenanthroimidazole in Verbindung mit Kristallviolettleukobase Aufzeichnungsmaterialien ergeben, die extrem lagerstabil sind und erst bei Bestrahlung mit aktinischem Licht zu einem sehr guten Farbumschlag führen.

Gegenstand der vorliegenden Erfindung ist ein fotochromes System, enthaltend einen oxidierbaren Leukofarbstoff und einen fotochemisch aktivierbaren Initiator, der den Leukofarbstoff in den Farbstoff überführt, das dadurch gekennzeichnet ist, daß der Initiator eine Verbindung der allgemeinen Formel (I) oder (II) ist,

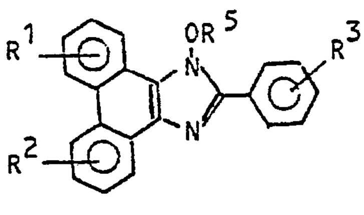

(I)

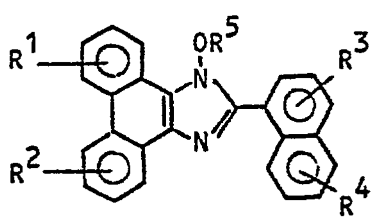

(II)

worin die Reste $R^1$ bis $R^4$ untereinander gleich oder verchieden sind und für Wasserstoff oder Alkyl-, Alkoxy-, Halogen- oder Aminoreste stehen und $R^5$ für Wasserstoff oder einen Alkyl-, Alkoxy- oder Arylalkylrest, einen Alkylsulfonyl-, Arylsulfonyl-, Dialkoxyphosphoryl-, Dialkylphosphoryl-, Diarylphosphoryl- oder einen Carbonylrest

$$-\underset{\underset{O}{\|}}{C}-R^6$$

steht, wobei $R^6$ für einen Alkyl-, Alkoxy-, Phenyl- oder Dialkylaminorest steht.

Gegenstand der vorliegenden Erfindung sind außerdem fotochrome Schichten, die ein derartiges fotochromes System, mindestens ein filmbildendes Polymer und weitere übliche Zusätze enthalten sowie die Verwendung dieser fotochromen Schichten zur Herstellung lithographischer Schichten für Photoresist, Offset, Hochdruck, Tiefdruck und für Ätztechnik auf Glas oder Aluminium.

So ergeben beispielsweise 1-Methoxy-2-phenylphenanthroimidazol oder 1-(N,N-Dibutylaminocarbonyloxy)-2-phenylphenanthroimidazol in Kombination mit Kristallviolettleukobase Aufzeichnungsmaterialien, die ausgezeichnet lagerstabil sind und erst bei Bestrahlung mit aktinischem Licht zu einem klar erkennbaren Farbumschlag führen.

Diese Phenanthroimidazolderivate können durch aktinisches Licht eines Wellenlängenbereichs von 250 bis 400 nm angeregt werden und gehen dabei in reaktive Spezies über, die zur Oxidation von substituierten Aminotriarylmethanen befähigt sind. In Frage kommen z.B. Bis(4-diethylaminophenyl)phenylmethan, Tris(4-diethylaminophenyl)methan, Tris(4-dimethylaminophenyl)methan.

Zu den das erfindungsgemäße fotochrome System bzw. die fotochromen Schichten aufbauenden Komponenten ist im einzelnen folgendes auszuführen.

Geeignete Leukofarbstoffe sind beispielsweise
Aminotriarylmethan-Verbindungen,
Aminoxanthen-Verbindungen,
Aminothioxanthen-Verbindungen,
Amino-9,10-dihydroacridin-Verbindungen,
Aminophenoxazin-Verbindungen,
Aminophenothiazin-Verbindungen,
Aminodihydrophenazin-Verbindungen,
Aminodiphenylmethan-Verbindungen,
Leukoindamin-Verbindungen
Aminohydrozimtsäuren,
Hydrazine
Leukoindigoidfarbstoffe,
Amino-2,3-dihydroanthrachinone,
Tetrahalogen-p,p-biphenole,
2-(p-Oxyphenyl)-4,5-diphenylimidazole und
Phenäthylanilin-Verbindungen.

Zu nennen sind hier
Aminotriarylmethan-Verbindungen, wie
Bis-(4-amino-2-butylphenyl)-(p-dimethylaminophenyl)-methan,
Bis-(4-amino-2-chlorphenyl)-(p-aminophenyl)-methan,
Bis-(4-amino-3-chlorphenyl)-(o-chlorphenyl)-methan,
Bis-(4-amino-3,5-diäthylphenyl)-(o-chlorphenyl)-methan,
Bis-(4-amino-3,5-diäthylphenyl)-(o-äthoxyphenyl)-methan,
Bis-(4-amino-3,5-diäthylphenyl)-(p-methoxyphenyl)-methan,
Bis-(4-amino-3,5-diäthylphenyl)-phenylmethan,
Bis(4-amino-3-äthylphenyl)-(o-chlorphenyl)-methan,
Bis-(p-aminophenyl)-(4-amino-m-tolyl)-methan,
Bis-(p-aminophenyl)-(o-chlorphenyl)-methan,
Bis-(p-aminophenyl)-(p-chlorphenyl)-methan,
Bis-(p-aminophenyl)-(2,4-dichlorphenyl)-methan,
Bis-(p-aminophenyl)-2,5-dichlorphenyl)-methan,
Bis-(p-aminophenyl)-(2,6-dichlorphenyl)-methan,
Bis-(p-aminophenyl)-phenylmethan,
Bis-(4-amino-o-tolyl)-(p-chlorphenyl)-methan,
Bis-(4-amino-o-tolyl)-(2,4-dichlorphenyl)-methan,
Bis-(p-anilinophenyl)-(4-amino-m-tolyl)-methan,
Bis-(4-benzylamino-2-cyanophenyl)-(p-aminophenyl)-methan,
Bis-(p-benzyläthylaminophenyl)-(p-chlorphenyl)-methan,
Bis-(p-benzyläthylaminophenyl)-(p-diäthylaminophenyl)-methan,
Bis-(p-benzyläthylaminophenyl)-(p-dimethylaminophenyl)-methan,
Bis-(4-benzyläthylamino-o-tolyl)-(p-methoxyphenyl)-methan,
Bis-(p-benzyläthylaminophenyl)-phenylmethan,
Bis-(4-benzyläthylamino-o-toyl)-(o-chlorphenyl)-methan,
Bis-(4-benzyläthylamino-o-tolyl)-(p-diäthylaminophenyl)-methan,

Bis-(4-benzyläthylamino-o-tolyl)-(4-diäthylamino-o-toyl)-methan,
Bis-(4-benzyläthylamino-o-tolyl)-(p-dimethylaminophenyl)-methan,
Bis-[2-chlor-4-(2-diäthylaminoäthyl)-äthylaminophenyl]-(o-chlorphenyl)-methan,
Bis-[p-bis-(2-cyanäthyl)-aminophenyl]-phenylmethan,
Bis-[p-(2-cyanäthyl)-äthylamino-o-tolyl]-(p-dimethylaminophenyl)-methan,
Bis-[p-(2-cyanäthyl)-methylaminophenyl]-(p-diäthylaminophenyl)-methan,
Bis-(p-dibutylaminophenyl)-[p-(2-cyanoäthyl)-methylaminophenyl]-methan,
Bis-(p-dibutylaminophenyl)-(p-diäthylaminophenyl)-methan,
Bis-(4-diäthylamino-2-butoxyphenyl)-(p-diäthylaminophenyl-)-methan,
Bis-(4-diäthylamino-2-fluorphenyl)-o-tolyl-methan,
Bis-(p-diäthylaminophenyl)-(p-aminophenyl)-methan,
Bis-(p-diäthylaminophenyl)-(4-anilin-1-naphthyl)-methan,
Bis-(p-diäthylaminophenyl)-(m-butoxyphenyl)-methan,
Bis-(p-diäthylaminophenyl)-(o-chlorphenyl)-methan,
Bis-(p-diäthylaminophenyl)-(p-cyanphenyl)-methan,
Bis-(p-diäthylaminophenyl)-(2,4-dichlorphenyl)-methan,
Bis-(p-diäthylaminophenyl)-(4-diäthylamino-1-naphthyl)-methan,
Bis-(p-diäthylaminophenyl)-(p-dimethylaminophenyl)-methan,
Bis-(p-diäthylaminophenyl)-(4-äthylamino-1-naphthyl)-methan,
Bis-(p-diäthylaminophenyl)-2-naphthylmethan,
Bis-(p-diäthylaminophenyl)-(p-nitrophenyl)-methan,
Bis-(p-diäthylaminophenyl)-2-pyridylmethan,
Bis-(p-diäthylamino-m-tolyl)-(p-diäthylaminophenyl)-methan,
Bis-(4-diäthylamino-o-tolyl)-(o-chlorphenyl)-methan,
Bis-(4-diäthylamino-o-tolyl)-(p-diäthylaminophenyl)-methan,
Bis-(4-diäthylamino-o-tolyl)-(p-diphenylaminophenyl)-methan,
Bis-(4-diäthylamino-o-tolyl)-phenylmethan,
Bis-(4-dimethylamino-2-bromphenyl)-phenyl-methan,
Bis-(p-dimethylaminophenyl)-(4-anilino-1-naphthyl)-methan,
Bis-(p-dimethylaminophenyl)-(p-butylaminophenyl)-methan,
Bis-(p-dimethylaminophenyl)-(p-sek.-butyläthylaminophenyl)-methan,
Bis-(p-dimethylaminophenyl)-(p-chlorphenyl)-methan,
Bis-(p-dimethylaminophenyl)-(p-diäthylaminophenyl)-methan,
Bis-(p-dimethylaminophenyl)-(4-dimethylamino-1-naphthyl)-methan,
Bis-(p-dimethylaminophenyl)-(6-dimethylamino-m-tolyl)-methan,
Bis-(p-dimethylaminophenyl)-(4-dimethylamino-o-tolyl)-methan,
Bis-(p-dimethylaminophenyl)-(4-äthylamino-1-naphthyl)-methan,
Bis-(p-dimethylaminophenyl)-(p-hexyloxyphenyl)-methan,
Bis-(p-dimethylaminophenyl)-(p-methoxyphenyl)-methan,
Bis-(p-dimethylaminophenyl)-(5-methyl-2-pyridyl)-methan,
Bis-(p-dimethylaminophenyl)-2-chinolylmethan,
Bis-(p-dimethylaminophenyl)-o-tolylmethan,
Bis-(p-dimethylaminophenyl)-(1,3,3-trimethyl-2-indolinylidenmethyl)-methan,
Bis-(4-dimethylamino-o-tolyl)-(p-aminophenyl)-methan,
Bis(4-dimethylamino-o-tolyl)-(o-bromphenyl)-methan,
Bis-(4-dimethylamino-o-tolyl)-(o-cyanophenyl)-methan,
Bis-(4-dimethylamino-o-tolyl)-(o-fluorphenyl)-methan,
Bis-(4-dimethylamino-o-tolyl)-1-naphthylmethan,
Bis-(4-dimethylamino-o-tolyl)-phenylmethan,
Bis-(p-äthylaminophenyl)-(o-chlorphenyl)-methan,
Bis-(4-äthylamino-m-tolyl)-(o-methoxyphenyl)-methan,
Bis-(4-äthylamino-m-tolyl)-(p-methoxyphenyl)-methan,
Bis-(4-äthylamino-m-tolyl)-(p-dimethylaminophenyl)-methan,
Bis-(4-äthylamino-m-tolyl)-(p-oxyphenyl)-methan,
Bis-[4-äthyl-(2-oxyäthyl)-amino-m-tolyl]-(p-diäthylaminophenyl)-methan,
Bis-[p-(2-oxyäthyl)-aminophenyl]-(o-chlorphenyl)-methan,
Bis-[p-(bis-(2-oxyäthyl)-aminophenyl]-(4-diäthylamino-o-tolyl)-methan,
Bis-[p-(2-methoxyäthyl)-aminophenyl]-phenylmethan,
Bis-(p-methylaminophenyl)-(o-oxyphenyl)-methan,
Bis-(p-propylaminophenyl)-(m-bromphenyl)-methan,
Tris-(4-amino-o-tolyl)-methan,
Tris-(4-anilin-o-tolyl)-methan,
Tris-(p-benzylaminophenyl)-methan,
Tris-(4-bis-(2-cyanäthyl)-amino-o-tolyl,-methan,
Tris-[p-(2-cyanäthyl)-äthylaminophenyl]-methan,

Tris-(4-dimethylaminophenyl)-methan,
Tris-(p-dibutylaminophenyl)-methan,
Tris-(p-di-tert.-butylaminophenyl)-methan,
Tris-(4-diäthylamino-2-chlorphenyl)-methan,
Tris-(p-diäthylaminophenyl)-methan,
Tris-(4-diäthylamino-o-tolyl)-methan,
Tris-(p-dihexylamino-o-tolyl)-methan,
Tris-(4-dimethylamino-o-tolyl)-methan,
Tris-(p-hexylaminophenyl)-methan]
Tris-[p-bis-(2-hydroxyäthyl)-aminophenyl]-methan,
Tris-(p-methylaminophenyl)-methan und
Tris-(p-dioctadecylaminophenyl)-methan;
Aminoxanthen-Verbindungen, wie
3-Amino-6-dimethylamino-2-methyl-9-(o-chlorphenyl)-xanthen,
3-Amino-6-dimethylamino-2ethyl-9-phenyl-xanthen,
3-Amino-6-dimethylamino-2-methylxanthen,
3,6-Bis-(diäthylamino)-9-(o-chlorphenyl)-xanthen,
3,6-Bis-(diäthylamino)-9-hexylxanthen,
3,6-Bis-(diäthylamino)-9-(o-methoxycarbonylphenyl)-xanthen,
3,6-Bis-(diäthylamino)-9-methylxanthen,
3,6-Bis-(diäthylamino)-9-phenylxanthen,
3,6-Bis-(diäthylamino)-9-o-tolylxanthen,
3,6-Bis-(dimethylamino)-9-(o-chlorphenyl)-xanthen,
3,6-Bis-(dimethylamino)-9-äthylxanthen,
3,6-Bis-(dimethylamino)-9-(o-methoxycarbonylphenyl)-xanthen und
3,6-Bis-(dimethylamino)-9-methylxanthen;
Aminothioxanthen-Verbindungen, wie
3,6-Bis-(diäthylamino)-9-(o-äthoxycarbonylphenyl)-thioxanthen,
3,6-Bis-(dimethylamino)-9-(o-methoxycarbonylphenyl)-thioxanthen,
3,6-Dianilin-9-(o-äthoxycarbonylphenyl)-thioxanthen,
Amino-9,1O-dihydroacridin-Verbindungen
3,6-Bis-(benzylamino)-9,1O-dihydro-9-methylacridin,
3,6-Bis-(diäthylamino)-9-hexyl-9,1O-dihydroacridin,
3,6-Bis-(diäthylamino)-9,1O-dihydro-9-methylacridin
3,6-Bis-(diäthylamino)-9,1O-dihydro-9-phenylacridin,
3,6-Diamino-9-hexyl-9,1O-dihydroacridin,
3,6-Diamino-9,1O-dihydro-9-methylacridin,
3,6-Diamino-9,1O-dihydro-9-phenylacridin,
3,6-Bis-(dimethylamino)-9-hexyl-9,1O-dihydroacridin und
3,6-Bis-(dimethylamino)-9,1O-dihydro-9-methylacridin;
Aminophenoxazin-Verbindungen, wie
3,7-Bis-(diäthylamino)-phenoxazin und
9-Dimethylamino-benzoa,-phenoxazin;
Aminophenthiazin-Verbindungen, wie
3,7-Bis-(benzylamino)-phenthiazin;
Aminodihydrophenazin-Verbindungen, wie
3,7-Bis-(benzyläthylamino)-5,1O-dihydro-5-phenylphenazin,
3,7-Bis-(diäthylamino)-5-hexyl-5,1O-dihydrophenazin,
3,7-Bis-(dihexylamino)-5,1O-dihydrophenazin,
3,7-Bis-(dimethylamino(-5-(p-chlorphenyl)-5,1O-dihydrophenazin,
3,7-Diamino-5-(o-chlorphenyl)-5,1O-dihydrophenazin,
3,7-Diamino-5,1O-dihydrophenazin,
3,7-Diamino-5,1O-dihydro-5-methylphenazin,
3,7-Diamino-5-hexyl-5,1O-dihydrophenazin,
3,7-Bis-(dimethylamino)-5,1O-dihydrophenazin,
3,7-Bis-(dimethylamino)-5,1O-dihydro-5-phenylphenazin und
3,7-Bis-(dimethylamino)-5,1O-dihydro-5-methylphenazin;
Aminodiphenylmethan-Verbindungen, wie
1,4-Bis-bis-p-(diäthylaminophenyl)-methyl,-piperzin,
Bis-(p-diäthylaminophenyl)-anilinomethan,
Bis-(p-diäthylaminophenyl)-1-benztriazolylmethan,
Bis-(p-diäthylaminophenyl)-2-benztriazolylmethan,
Bis-(p-diäthylaminophenyl)-(p-chloranilin)-methan,
Bis-(p-diäthylaminophenyl)-(2,4-dichloranilin)-methan,
Bis-(p-diäthylaminophenyl)-(methylamino)-methan,

Bis-(p-diäthylaminophenyl)-(octadecylamino)-methan,
Bis-(p-dimethylaminophenyl)-aminomethan,
Bis-(p-dimethylaminophenyl)-anilinmethan,
1,1-Bis-(dimethylaminophenyl)-äthan,
1,1-Bis-(dimethylaminophenyl)-heptan und
Bis-(4-methylamino-m-tolyl)-aminoäthan;

Leuko-Indamin-Verbindungen, wie
4-Amino-4'-dimethylaminodiphenylamin und
p-(p-Dimethylaminoanilin)-phenol;

Aminohydrozimtsäuren (Cyanoäthane, Leukomethine), wie
4-Amino-alpha-beta-dicyanohydrozimtsäure,
Methylester,
4-Anilino-alphabeta-dicyanohydrozimtsäure,
Methylester,
4-(p-Chloranilino)-alpha,beta-dicyanohydrozimtsäure,
Methylester,
alpha-Cyano-4-dimethylaminohydrocinnamid,
alpha-Cyano-4-dimethylaminohydrozimtsäure,
Methylester,
alpha,beta-Dicyano-4-diäthylaminohydrozimtsäure,
Methylester,
alpha,beta-Dicyano-4-dimethylaminohydrocinnamid,
alpha,beta-Dicyano-4-dimethylaminohydrozimtsäure,
Methylester,
alpha,beta-Dicyano-4-dimethylaminohydrozimtsäure,
alpha,beta-Dicyano-4-dimethylaminohydrozimtsäure,
Hexylester,
alpha,beta-Dicyano-4-äthylaminohydrozimtsäure,
Methylester,
alpha,beta-Dicyano-4-hexylaminohydrozimtsäure,
Methylester,
alpha,beta-Dicyano-4-methylaminozimtsäure,
Methylester,
p-(2,2-Dicyanoäthyl)-N,N-dimethylanilin,
4-Methoxy-4'-(1,2,2-tricyanoäthyl)-azobenzol,
4-(1,2,2-Tricyanoäthyl)-azobenzol und
p-(1,2,2-Tricyanoäthyl)-N,N-dimethylanilin;

Hydrazine, wie
1-(p-Diäthylaminophenyl)-2-(2-pyridyl)-hydrazin,
1-(p-Dimethylaminophenyl)-2-(2-pyridyl)-hydrazin,
1-(3-Methyl-2-benzothiazolyl)-2-(4-hydroxy-1-naphthyl)-hydrazin,
1-(2-Naphthyl)-2-phenylhydrazin,
1-p-Nitrophenyl-2-phenylhydrazin und
1-(1,3,3-Trimethyl-2-indolinyl)-2-(3-N-phenylcarbamoyl-4-oxy-1-naphthyl)-hydrazin;

Amino-2,3-dihydroanthrachinone, wie
1,4-Dinilino-2,3-dihydroanthrachinon und
1,4-Bis-(äthylamino)-2,3-dihydroanthrachinon;

Phenäthylanilin-Verbindungen, wie
N-(2-Cyanoäthyl)-p-phenäthylanilin,
N,N-Diäthyl-p-phenyläthylanilin,
N,N-Dimethyl-p-[2-(1-naphthyl)-äthyl]-anilin,
N,N-Dimethyl-p-[2-(4-nitro-1-naphthyl)-äthyl]-anilin,
N,N-Dimethyl-p-phenäthylanilin,
N,N-Dimethyl-p-[2-(4-methoxy-1-naphthyl)-äthyl]-anilin
p-(p-Methoxyphenäthyl)-anilin,
p-[2-(1-Naphthyl)-äthyl]-anilin,
p-(p-Nitrophenäthyl)-anilin und
p-Phenäthylanilin,
sowie gegebenenfalls Gemische dieser Leukofarbstoffe.

Erfindungsgemäße geeignete fotochemisch aktivierbare Initiatoren sind Verbindungen der allgemeinen Formel (I) oder (II)

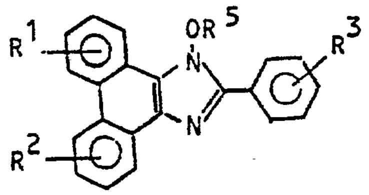

(I) (I)

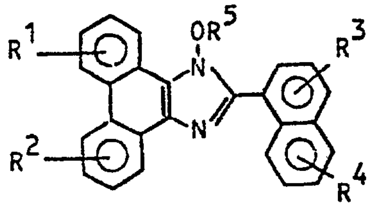

(II) (II)

worin die Reste $R^1$ bis $R^4$ untereinander gleich oder verschieden sind und für Wasserstoff oder Alkyl-, Alkoxy-, Halogen- oder Aminoreste stehen und
$R^5$ für Wasserstoff oder einen Alkyl-, Alkoxy- oder Arylalkylrest, einen Alkylsulfonyl-, Arylsulfonyl-, Dialkoxyphosphoryl-, Dialkylphosphoryl-, Diarylphosphoryl- oder einen Carbonylrest

$$-\underset{\underset{O}{\|}}{C}-R^6$$

steht, wobei $R^6$ für einen Alkyl-, Alkoxy-, Phenyl- oder Dialkylaminorest steht,
Als Alkylreste $R^1$ bis $R^5$ kommen geradkettige oder verzweigte Alkylreste mit 1 bis 18, vorzugsweise 1 bis 6 Kohlenstoffatomen oder Cyclohexylreste in Frage, beispielsweise Methyl-, Äthyl-, n-Propyl-, Isopropyl-, n-Butyl-, Isobutyl-, tert.-Butyl-, Pentyl-, Hexyl-, Heptyl-, Octyl-, Isooctyl-, 2-Äthylhexyl-, Decyl-, Undecyl-, Dodecyl-, Stearylreste;
als Alkoxyreste $R^1$ bis $R^5$ kommen geradkettige oder verzweigte Alkoxyreste mit 1 bis 18, vorzugsweise 1 bis 6 Kohlenstoffatomen in Betracht, beispielsweise Methoxy-, Äthoxy-, Propoxy-, Butoxy-, Pentyloxy-, Hexyloxyreste;
geeignete Halogenreste $R^1$ bis $R^4$ sind Fluor, Chlor, Brom, Jod, vorzugsweise Chlor;
geeignete Aminoreste $R^1$ bis $R^4$ sind $-NH_2$, Mono- und Dialkylaminoreste mit 1 bis 6 Kohlenstoffatomen in den Alkylgruppen;
geeignete Arylalkylreste $R^5$ sind z.B. Benzylreste.
In Carbonylresten $R^5$ der Formel

$$-\underset{\underset{O}{\|}}{C}-R^6,$$

kann $R^6$ für einen Alkylrest mit 1 bis 18, vorzugsweise 1 bis 12 Kohlenstoffatomen, für einen Alkoxyrest mit 1 bis 18, vorzugsweise 1 bis 6 Kohlenstoffatomen, für einen Phenylrest oder einen Dialkylaminorest mit 1 bis 6 Kohlenstoffatomen in den Alkylgruppen stehen; Beispiele für Reste $R^6$ sind Methyl, Butyl, Trimethylphenyl und Toluyl;
geeignete Alkylsulfonylreste $R^5$ sind beispielsweise solche mit 1 bis 18, vorzugsweise 1 bis 6 Kohlenstoffatomen in der Alkylgruppe;
als Arylsulfonylreste $R^5$ kommen z.B. der Phenylsulfonylrest oder 4-Methylphenylsulfonylrest in Betracht;
geeignete Dialkoxyphosphorylreste $R^5$ sind beispielsweise solche mit 1 bis 12, vorzugsweise 1 bis 6 Kohlenstoffatomen in den Alkoxyresten;
als Dialkylphosphorylreste $R^5$ kommen z.B. solche mit 1 bis 12, vorzugsweise 1 bis 6 Kohlenstoffatomen in den Alkylgruppen in Frage;
ein geeigneter Diarylphosphorylrest $R^5$ ist z.B. der Diphenylphosphorylrest.
Beispiele für fotochemisch aktivierbare Initiatoren, die diesen Formeln (I) bzw. (II) entsprechen, sind:
1-Methoxy-2-phenylphenanthroimidazol,
1-Benzyloxy-2-phenylphenanthroimidazol,
1-(N,N-Dibutylaminocarbonyloxy)-2-phenylphenanthroimidazol,
1-Acetoxy-2-phenylphenanthroimidazol und
1-Acetoxy-2(2-chlorphenyl)-phenanthroimidazol.
Der fotochemisch aktivierbare Initiator wird mit dem Leukofarbstoff im allgemeinen in einem Gewichtsverhältnis von 1 : 1 bis 1O : 1 kombiniert.

Das erfindungsgemäße fotochrome System wird vorzugsweise zur Herstellung fotochromer Schichten verwendet. Diese fotochromen Schichten enthalten neben dem fotochromen System mindestens ein filmbildendes Polymer sowie weitere übliche Zusätze, wie Vernetzer, reaktive Kettenverlängerer, Weichmacher, Stabilisatoren, Fotoinitiatoren und deren Gemische.

Die fotochromen Schichten enthalten im allgemeinen O,O1 bis 1O %, vorzugsweise O,1 bis 1 % Leukofarbstoff und O,1 bis 2O, vorzugsweise O,5 bis 5 % fotochemisch aktivierbaren Initiator.

Als filmbildende Polymere kommen übliche Homo- und Copolymerisate in Betracht, soweit sie die für dieses Einsatzgebiet gewünschten Eigenschaften aufweisen, beispielsweise Homo- und Copolymerisate von Acrylsäure- oder Methacrylsäureestern mit 1 bis 8 Kohlenstoffatome enthaltenden Monoalkanolen, z.B. Methanol, Butanol, 2-Ethylhexylalkohol, Copolymerisate von Vinylaromaten, wie z.B. von Styrol oder Vinyltoluol, Vinylestercopolymerisate, Vinylchlorid- und Vinylidenchlorid-Copolymerisate, N-Vinylpyrrolidon(Co)polymerisate teilweise verseiftes Polyvinylacetat, Olefin/(Meth-)-acrylester-Copolymerisate und Olefin/Vinylester-Copolymerisate, wobei als Olefine Äthylen, Propylen und/oder Butadien Frage kommen. Diese Copolymerisate können auch funktionelle Gruppen, wie -COOH -OH und/oder -$NH_2$ durch Einpolymerisieren von Monomeren mit entsprechenden Gruppen enthalten.

Als filmbildende Polymere kommen ebenso Polykondensate und Polyaddukte in Betracht, wie Polyester, Polyurethane und insbesondere Polyamide. Besonders bevorzugte filmbildende Polymere, die üblicherweise in Form ihrer Lösung (mit Aceton, Methylenchlorid, THF, Essigester, Methylethylketon als Lösungsmittel) auf das zu beschichtende Substrat, wie z.B. Polyester-Folie oder Aluminium aufgetragen und getrocknet werden, sind z.B. Copolymerisate von Methylmethacrylat mit Acrylsäure, Styrol und Hydroxypropylacrylat.

Die weiteren üblichen Zusätze variieren je nach speziellem Verwendungszweck.

Sofern es sich um fotopolymerisierbare Schichten handelt, enthalten diese fotopolymerisierbare Monomere, wie polyfunktionelle Acrylsäure- und/oder Methacrylsäureester, wie die Ester der Acryl- oder Methacrylsäure mit zwei- und mehrwertigen Alkoholen, wie Äthylenglykol, Propylenglykol, Butandiol, Hexandiol, Trimethylolpropan, Glycerin, Pentaerythrit und ähnliche, die Umsetzungsprodukte von (Poly)epoxidverbindungen mit (Meth-)acrylsäure, Urethanacrylate, ungesättigte Polyester, sowie Gemische der vorgenannten polyfunktionellen Verbindungen mit monofunktionellen Verbindungen, wie Ester der Acrylsäure oder Methacrylsäure mit $C_1$-bis $C_{20}$-Monoalkanolen, Vinylestern, Vinylaromaten und/oder N-Vinyllactamen wie z.B. N-Vinylpyrrolidon.

Als weitere mögliche Zusätze sind Hilfs- und Zusatzstoffe, wie Stabilisatoren, weitere Fotoinitiatoren sowie Sensibilisatoren zu erwähnen, die im allgemeinen in untergeordneten Mengen eingesetzt werden.

Die erfindungsgemäßen fotochromen Schichten können beispielsweise zur Herstellung lithographischer Schichten für Fotoresist, Offset, Hochdruck, Tiefdruck, Ätztechnik (z.B. auf Glas oder Aluminium) eingesetzt werden. Diese Verfahren sind beispielsweise in DE-OS 32 31 145, DE-OS 32 31 147, DE-OS 33 31 691 und DE-OS 32 31 144 beschrieben.

Die erfindungsgemäßen fotochromen Systeme zeichnen sich besonders durch ihre gute Lagerstabilität aus. Sie eignen sich besonders bei negativ arbeitenden Fotoresistfilmen.

Die im Vergleichsbeispiel und in den Beispielen genannten Teile und Prozente sind, soweit nicht anders angegeben, Gewichtsteile und Gewichtsprozente.

Vergleichsbeispiel

Eine Mischung, bestehend aus 55 Teilen Polymethylmethacrylat (z.B. Degalan(R) LP 5O/O9) 18 Teilen Trimethylolpropantriacrylat, 13,5 Teilen Butandioldiacrylat, 9,4 Teilen p-Toluolsulfonsäureamid, O,15 Teilen Michler's Keton, 3,4 Teilen Benzophenon, O,45 Teilen Kristallviolettleukobase in 155 Teilen Essigsäureethylester, wurde hergestellt und mit 3 Teilen 2,2'-Bis(2-chlorphenyl)-4,4',5,5'-tetrakis(4-methoxyphenyl)-bisimidazol versetzt. Nach vierstündigem Rühren wurde die Lösung durch einen Druckfilter mit 1 µm Porendurchmesser filtriert und auf eine O,O23 mm dicke Polyesterfolie (z.B. Melinex(R) S 23 der Firma ICI) in solcher Menge schichtförmig gegossen, daß nach dem Trocknen mit Warmluft ein Resistfilm von O,O35 mm Dicke verblieb. Der Resistfilm wurde bei 12O°C/1,5 m $min^{-1}$ in einem handelsüblichen Laminator (z.B. im HOT-ROLL-Laminator HRL 24) auf gebürstetes Kupfer laminiert. Der Photolack wurde in einem üblichen Flachbelichter (z.B. im MOLL-Flachbelichter) durch die Vorlage eines elektrischen Schaltbildes 1 bis 3 Minuten lang belichtet. Man erhielt einen guten Farbumschlag zwischen belichteten und unbelichteten Bildteilen. Die mit diesem Resistfilm beschichtete Kupferplatte wurde bei 5O°C gelagert. Spätestens nach 1O Tagen erhielt man eine sehr starke Blaufärbung des Fotoresistfilms.

Beispiel 1

Wie im Vergleichsbeispiel beschrieben, wurde ein Resistfilm mit 2,5 Teilen 1-Methoxy-2-phenylphenanthroimidazol anstelle von 3 Teilen des dort genannten Hexaarylbisimidazol hergestellt. Die bildmäßige Belichtung lieferte einen sehr guten Farbkontrast zwischen belichteten und unbelichteten Bildteilen, der dem Augenschein nach mit dem Farbkontrast des Vergleichsbeispiels 1 nahezu übereinstimmt. Die thermische Lagerung als Test für die Langzeitstabilität zeigte, daß dieses neue Farbstoffsystem wesentlich

besser ist als das im Vergleichsbeispiel 1 angeführte System. So trat selbst nach dreiwöchiger Lagerung bei 5O°C noch keine Verfärbung der Resistschicht auf.

Beispiel 2

Das Fotooxidationsmittel 1-(N,N-Dibutylaminocarbonyloxy)-2-phenylphenanthroimidazol verhält sich ähnlich gut wie das in Beispiel 1 genannte 1-Methoxy-2-phenylphenanthroimidazol.

Beispiel 3-8

Zur Charakterisierung der fotochemisch aktiven Oxidationsmittel aus der Reihe der Phenanthroimidazole wurden Belichtungsserien durchgeführt. Die Resistschichten hatten die Zusammensetzung des Vergleichsbeispiels 1 mit dem Unterschied, daß anstelle des dort genannten Hexaarylbisimidazols 2,5 Teile des in der Tabelle angegebenen Phenanthroimidazols eingesetzt wurden. Die Belichtung erfolgte mit einem handelsüblichen Flachbelichter. Die angeführten ΔOD-Werte (= Änderung der optischen Dichte nach 1 bzw. 3 Minuten Belichtungszeit) geben die Extinktion bei 6OO nm des fotochemisch erzeugten Kristallvioletts an; sie sind also ein Maß für die fotochemische Oxidationskraft der eingesetzten Phenanthroimidazol-Derivate.

| Beispiel | Fotooxidationsmittel | Δ OD nach 1 Minute | Δ OD nach 3 Minuten |
|---|---|---|---|
| 3 | 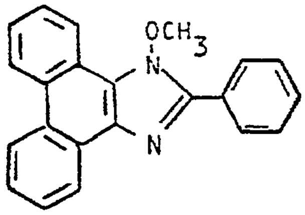 | 0,3 | 0,5 |
| 4 | 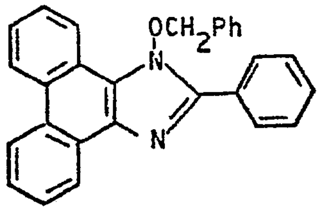 | 0,1 | |
| 5 | 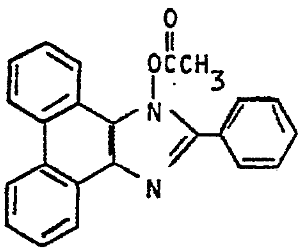 | 1,3 | |
| 6 | 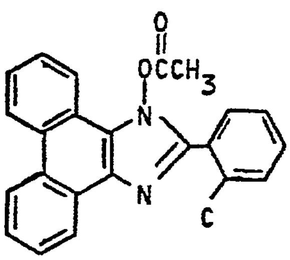 | 1,3 | |
| 7 | 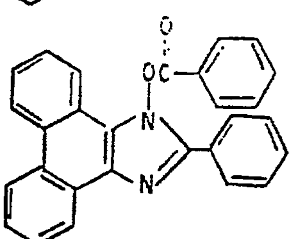 | 1,4 | |
| 8 | 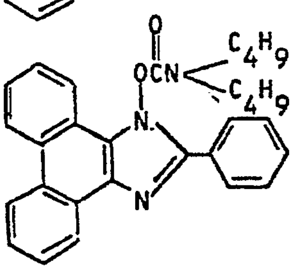 | 0,3 | 0,5 |

Beispiel 9

Anstelle von 2-Methoxy-2-phenylphenanthroimidazol wurde das 1-Hydroxy-2-phenylphenanthroimidazol zu O,5 Teilen in der obigen Rezeptur eingesetzt. Auch diese Verbindung führt zu einem ausgezeichneten Farbumschlag.

## Patentansprüche

1. Fotochromes System, enthaltend einen oxidierbaren Leukofarbstoff und einen fotochemisch aktivierbaren Initiator, der den Leukofarbstoff in den Farbstoff überführt, dadurch gekennzeichnet, daß der Initiator eine Verbindung der allgemeinen Formel (I) oder (II) ist,

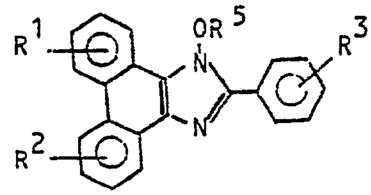

(I)

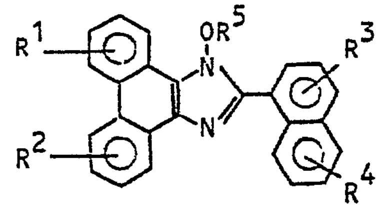

(II)

worin die Reste $R^1$ bis $R^4$ untereinander gleich oder verschieden sind und für Wasserstoff oder Alkyl-, Alkoxy-, Halogen- oder Aminoreste stehen und
$R^5$ für Wasserstoff oder einen Alkyl-, Alkoxy- oder Arylalkylrest, einen Alkylsulfonyl-, Arylsulfonyl-, Dialkoxyphosphoryl-, Dialkylphosphoryl-, Diarylphosphoryl- oder einen Carbonylrest

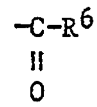

steht,
wobei $R^6$ für einen Alkyl-, Alkoxy-, Phenyl- oder Dialkylaminorest steht.

2. Fotochrome Schicht, die ein fotochromes System, mindestens ein filmbildendes Polymer und weitere übliche Zusätze enthält, dadurch gekennzeichnet, daß sie das fotochrome System gemäß Anspruch 1 enthält.

3. Verwendung der fotochromen Schicht nach Anspruch 2 zur Herstellung lithographischer Schichten für Photoresist, Offset, Hochdruck, Tiefdruck oder für Ätztechnik auf Glas oder Aluminium.

## Claims

1. A photochromic system containing an oxidizable leuco dye and a photochemically activatable initiator which converts the leuco dye to the dye, wherein the initiator is a compound of the formula (I) or (II)

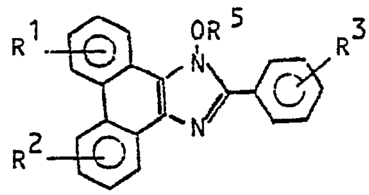

(I)

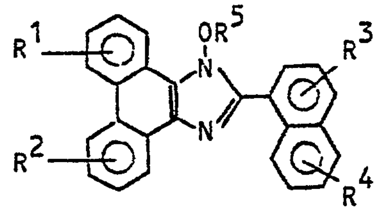

(II)

where $R^1$, $R^2$, $R^3$ and $R^4$ are identical or different and are each hydrogen, alkyl, alkoxy, halogen or ami-

no, $R^5$ is hydrogen, alkyl, alkoxy, aralkyl, alkylsulfonyl, dialkoxyphosphoryl, dialkylphosphoryl, diarylphosphoryl or a carbonyl radical

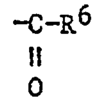

and $R^6$ is alkyl, alkoxy, phenyl or dialkylamino.

2. A photochromic layer which contains a photochromic system, one or more film-forming polymers and other conventional additives, wherein the said photochromic layer contains the photochromic system as claimed in claim 1.

3. Use of a photochromic layer as claimed in claim 2 for the production of a lithographic layer for photoresist, offset printing, letterpress printing or gravure printing or for etching glass or aluminum.

## Revendications

1. Système photochrome, contenant un leuco-colorant oxydable et un initiateur activable photochimiquement qui transforme le leuco-colorant en le colorant, caractérisé par le fait que l'initiateur est un composé de la formule générale (I) ou (II),

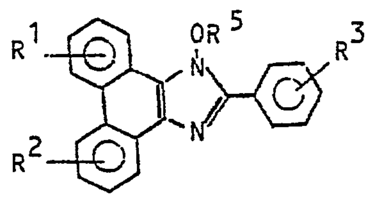

(I)

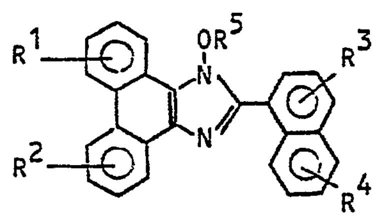

(II)

où les restes $R^1$ à $R^4$ sont identiques ou différents les uns des autres et sont mis pour hydrogène ou un reste alkyle, alcoxy, halogène ou amino, et

$R^5$ est mis pour hydrogène ou un reste alkyle, alcoxy ou arylalkyle, un reste alkylsulfonyle, arylsulfonyle, dialkoxyphosphoryle, dialkylphosphoryle, diarylphosphoryle ou un reste carbonyle

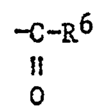

$R^6$ étant mis pour un reste alkyle, alcoxy, phényle ou dialkylamino.

2. Couche photochrome, qui contient un système photochrome, au moins un polymère filmogène et autres additifs usuels, caractérisée par le fait qu'il contient le système photochrome selon la revendication 1.

3. Utilisation de la couche photochrome selon la revendication 2 pour la fabrication de couches lithographiques pour photoréserves (photoresist), offset, impression typo, impression en creux ou technique de mordançage sur verre ou aluminium.